Europäisches Patentamt

European Patent Office

Office européen des brevets

(11) Veröffentlichungsnummer: **0 451 690 A2**

# (12) EUROPÄISCHE PATENTANMELDUNG

(21) Anmeldenummer: **91105289.2**

(22) Anmeldetag: **03.04.91**

(51) Int. Cl.5: **H05K 13/00**

(30) Priorität: **09.04.90 DE 4011434**

(43) Veröffentlichungstag der Anmeldung:
**16.10.91 Patentblatt 91/42**

(84) Benannte Vertragsstaaten:
**DE FR GB IT**

(71) Anmelder: **ATG ELECTRONIC GmbH**
**Zum Schlag 3**
**W-6980 Wertheim-Reicholzheim(DE)**

(72) Erfinder: **Prokopp, Manfred**
**Am Felder 27**
**W-6980 Wertheim(DE)**
Erfinder: **Giringer, Klaus**
**Ehbühl 14**
**W-7033 Herrenberg(DE)**

(74) Vertreter: **Gleiss, Alf-Olav, Dipl.-Ing. et al**
**Patentanwalt Silberburg Strasse 187**
**W-7000 Stuttgart 1(DE)**

(54) **Verfahren und Vorrichtung zum Bohren und/oder Bestücken der Führungsplatten eines Prüfadapters.**

(57) Bei einem Verfahren zum Bohren und/oder Bestücken der auswechselbaren Führungsplatten eines Prüfadapters werden zum Bohren der Führungsbohrungen alle Führungsplatten oder n-1 Führungsplatten aufeinander gelegt oder in geringen Abständen voneinander angeordnet, und in diesen Führungsplatten werden die Reihen von Führungsbohrungen nacheinander in pro Reihe jeweils einem einzigen Bohrvorgang gebohrt, wobei diejenigen Reihen von Führungsbohrungen, deren Längsachsen vor dem Bohren nicht miteinander fluchten, vor der Vornahme des jeweiligen Bohrvorganges in Fluchtung ihrer Führungsbohrungen durch Verschieben mindestens einer der Führungsplatten gebracht werden. Alternativ werden die Kontaktstifte in die Führungsbohrungen aller Führungsplatten nacheinander eingesetzt, wobei die Führungsbohrungen jeder Führungsbohrungsreihe vor Einsetzen des betreffenden Kontaktstiftes, falls sie außer Fluchtung sind, durch Verschieben von vorzugsweise n-1 Führungsplatten parallel zu sich selbst in Fluchtung gebracht werden.

FIG.2

EP 0 451 690 A2

Die Erfindung betrifft ein Verfahren zum Bohren und/oder Bestücken der Führungsplatten eines Prüfadapters gemäß dem Oberbegriff des Anspruches 1 und eine Vorrichtung zur Durchführung des Verfahrens.

Solche Prüfadapter mit mindestens drei im Abstand voneinander angeordneten Führungsplatten für die Kontaktstifte hat man bisher mit den Führungsbohrungen in der Weise versehen, daß jede dieser Platten einzeln gebohrt wurde. Dies deshalb, weil die Bohrungen in den Führungsplatten zum Teil nicht deckungsgleich sind. Und zwar dienen solche Prüfadapter dem Kontaktieren von Prüflingen, wie insbesondere Leiterplatten, bei denen die Prüfpunkte zum Teil nicht an Gitterpunkten eines vorbestimmten Rasters angeordnet sind, also zum Teil außer Raster liegen. Das Rastermaß kann bspw. 1 bis 3 mm betragen oder auch noch größer oder kleiner sein. Die Prüfpunkte am jeweiligen Prüfling, bei dem es sich vorzugsweise um eine Leiterplatte handeln kann, die außer Raster liegen, müssen dann mittels Kontaktstiften kontaktiert werden, deren Führungsbohrungen in der dem Prüfling benachbarten Führungsplatte entsprechend außer Raster liegen. Dagegen ist die rückwärtige Führungsplatte des Prüfadapters nur mit im Raster liegenden Führungsbohrungen versehen, weil nämlich diesen Führungsbohrungen ein Kontaktfeld zugeordnet ist, dessen gegeneinander elektrisch isolierten Kontakte im Raster liegen, um für Prüflinge mit unterschiedlichen Prüfpunktanordnungen geeignet zu sein. Es ist bspw. bekannt, das Kontaktfeld durch in einem Träger angeordnete Federkontaktstifte zu bilden, deren über die Hülsen überstehenden, durch in den Hülsen angeordnete Federn belasteten Kolbenglieder über die Hülsen überstehen und an ihren vorderen Enden elektrische Kontakte aufweisen, die von den Kontaktstiften zu deren elektrischen Anschluß an das Testgerät der betreffenden Prüfvorrichtung kontaktierbar sind. Dabei weist dieses Kontaktfeld an allen Gitterpunkten des Rasters je einen solchen Federkontaktstift auf und alle Federkontaktstifte sind parallel zueinander. Der jeweils zum Kontaktieren eines Prüflings mit einer vorbestimmten Prüfpunktanordnung dienende Prüfadapter weist stets weniger Kontaktstifte auf, als der Anzahl der Gitterpunkte des Rasters und damit der Anzahl der genannten Kontakte oder Federkontaktstifte entspricht. Im Prüfadapter werden deshalb nur so viel Kontaktstifte angeordnet, wie Prüfpunkte am betreffenden Prüfling vorhanden sind. Die Kontakte des Kontaktfeldes sind an das die Prüfungen der Prüflinge auf Fehlerfreiheit elektrisch durchführende Prüfgerät, auch Testgerät genannt, ständig elektrisch angeschlossen, das so ausgebildet ist, daß es für eine Serie von unter sich gleichen Prüflingen dadurch für dessen Prüfung selbsttätig programmiert werden kann, indem die Kontaktstifte des Prüfadapters einen vorher als fehlerfrei befundenen Prüfling an allen Prüfpunkten kontaktieren und dieses Testgerät kann sich dann selbst für diesen Prüfling und entsprechend auch für alle Prüflinge desselben Typs programmieren. Wenn eine Serie von Prüflingen anderer Prüfpunktanordnung zu prüfen ist, wurden die Führungsplatten ggf. mit Ausnahme der hinteren Führungsplatte einzeln neu gebohrt. Dann wurden diese Führungsplatten im Prüfadapter befestigt und mit Kontaktstiften bestückt. Dieses Bestücken macht besondere Maßnahmen wegen derjenigen Führungsbohrungsreihen der Führungsplattenanordnung erforderlich, deren in sie eingesetzte Kontaktstifte am Prüfling außer Raster angeordnete Prüfpunkte zu kontaktieren haben, weil diese Kontaktstifte im Prüfadapter schräg zu den Normalen der zueinander parallelen Führungsplatten gerichtet sind. Um diese Bestückung durchzuführen, ist es bekannt, so viel mittlere Führungsplatten am Prüfadapter vorzusehen, bspw. zwei bis vier, daß ein Kontaktstift, der bei vertikal gerichtetem Prüfadapter in eine Führungsbohrung der oberen Führungsplatte eingesetzt wird, geleitet durch die zugeordneten Führungsbohrungen der mittleren Führungsplatte oder -platten in alle zugeordneten Führungsbohrungen der Führungsplatten fällt. Jedoch macht dies im allgemeinen mehrere mittlere Führungsplatten erforderlich. Der Aufwand für den Prüfadapter wird durch das einzelne Bohren der Führungsplatten umso höher, je mehr Führungsplatten für das Einfädeln der Kontaktstifte beim Bestücken erforderlich sind. Am einfachsten wäre es, am Prüfadapter nur eine vordere und eine hintere Führungsplatte und also keine mittleren Führungsplatten vorzusehen. Die Führung der Kontaktstifte ist dann jedoch oft nicht zufriedenstellend. Auch sind Fehler beim Einsetzen der Kontaktstifte möglich, und es muß das Einsetzen der Kontaktstifte in diese beiden Führungsplatten von Hand erfolgen, was im Hinblick auf die meist sehr große Anzahl von Kontaktstiften - im allgemeinen weist ein Prüfadapter mehrere hundert bis oft viele tausend Kontaktstifte auf - sehr erhebliche Kosten verursacht.

Es ist deshalb eine Aufgabe der Erfindung, ein Verfahren der im Oberbegriff des Anspruches 1 genannten Art zu schaffen, das kostengünstiges Bohren und/oder Bestücken der Führungsplatten eines Prüfadapters ermöglicht und dennoch sichere Führung und/oder fehlerfreies Einsetzen der Kontaktstifte durch die Führungsplatten bzw. in die Führungsplatten erreichen läßt.

Diese Aufgabe wird durch das in Anspruch 1 angegebene Verfahren gelöst. Vorrichtungen zur Durchführung dieses Verfahrens sind in den Ansprüchen 5 und 6 beschrieben.

Dieses Verfahren ermöglicht bezüglich des Bohrens der Führungsplatten sehr kostengünstiges Bohren, weil alle Führungsplatten oder alle Führungsplatten mit Ausnahme der rückwärtigen Führungsplatte pro Führungsbohrungsreihe durch einen Bohrer in einem Bohrvorgang gebohrt werden. Der Zeitaufwand für dieses Bohren wird also sehr stark reduziert und kann mittels eines Automaten vorgenommen werden. Auch ist genaue Fluchtung der Führungsbohrungen der Bohrungsreihen gewährleistet.

Das Bestücken der Führungsplatten des Prüfadapters mit Kontaktstiften ist einfach und kostengünstig durchführbar, indem die Bohrungsreihen, die der Aufnahme von Kontaktstiften dienen, die außer Raster liegenden Prüfpunkte der Prüflinge der betreffenden Prüflingsserie kontaktieren, vor dem Einsetzen der Kontaktstifte jeweils in Fluchtung miteinander gebracht werden. Es kann dann der einzelne Kontaktstift in eine solche fluchtende Führungsbohrungsreihe durch eine auf sie zielende Kontaktstift-Führungsvorrichtung eingesetzt werden. Dabei können vorzugsweise die Führungsplatten horizontal und entsprechend die Führungsbohrungsreihen beim Einsetzen von Kontaktstiften vertikal gerichtet sein, so daß die Kontaktstifte in die Führungsbohrungsreihen fallen können, doch ist es auch möglich, die Kontaktstifte für das Einsetzen durch eine sie unbeweglich haltende Haltevorrichtung in Fluchtung mit der jeweiligen Führungsbohrungsreihe zu halten und sie durch gerades Bewegen der Haltevorrichtung in die jeweilige Führungsbohrungsreihe einzusetzen, so daß diese dabei nicht vertikal ausgerichtet sein muß.

Das Einsetzen der Kontaktstifte in die Führungsbohrungsreihen der Führungsplatten kann selbttätig erfolgen, bspw. mittels eines Automaten, der sie nacheinander in die Führungsbohrungsreihen einsetzt, wobei jede Führungsbohrungsreihe, deren Führungsbohrungen auf einen außer Raster liegenden Prüfpunkt eines Prüflings zielen, vor dem Einsetzen des betreffenden Kontaktstiftes in Fluchtung gebracht werden.

Falls im Falle vertikalen Einsetzens der Kontaktstifte in die Führungsbohrungsreihen die Gefahr besteht, daß beim Bestücken der Führungsplatten mit Kontaktstiften nicht alle oder ein Teil der Kontaktstifte nicht durch ihre Schwerkraft allein durch die Führungsbohrungen der jeweils zugeordneten Führungsbohrungsreihen fallen, kann vorzugsweise vorgesehen sein, daß ein Stempel die Kontaktstifte vollends in die Führungsbohrungen der Führungsbohrungsreihen einführt.

Die hintere Führungsplatte der Führungsplattenanordnung für den Prüfadapter weist ausschließlich im Raster liegende Führungsbohrungen auf. Diese Führungsplatte kann so ausgebildet sein, daß sie für alle Kontakte eines ihr zugeordneten, von den Kontaktstiften zu deren elektrischem Anschluß kontaktierbaren elektrischen Kontakten eines Kontaktfeldes Führungsbohrungen aufweist, wobei jeder solcher Führungsbohrungsreihe ein Kontakt des Kontaktfeldes zugeordnet ist. Da die Anzahl der Kontaktstifte eines Prüfadapters normalerweise kleiner, meist viel kleiner als die Anzahl der Gitterpunkte des Rasters ist, bleiben dann beim Bestücken der Führungsplatten des Prüfadapters eine mehr oder weniger große Anzahl der Führungsbohrungen der hinteren Führungsplatte leer. Jedoch hat eine derart gebohrte hintere Führungsplatte den Vorteil, daß sie bei Prüflingen mit unterschiedlichen Prüfpunktanordnungen verwendet werden kann, sofern der dem Prüfling zugeordnete Raster derselbe wie der der Führungsbohrungen der hinteren Führungsplatte ist. Man braucht dann nur die vordere und die mindestens eine mittlere Führungsplatte in der erfindungsgemäßen Weise zu bohren, d.h., daß jede ihrer Reihen von Führungsbohrungen durch einen einzigen Bohrvorgang gebohrt wird, also durch eine einzige Bohrbewegung des betreffenden Bohrers. Die Führungsbohrungen werden dabei nacheinander gebohrt.

Es ist jedoch auch möglich, jeweils alle Führungsplatten, also auch die hintere Führungsplatte gemeinsam zu bohren und bei Änderung der Prüfpunktanordnung muß dann auch die hintere Führungsplatte mit gebohrt werden.

Eine Vorrichtung zum Bohren aller Führungsplatten bzw. aller Führungsplatten mit Ausnahme der hinteren Führungsplatte eines Prüfadapters weist Haltevorrichtungen zum Halten der zu bohrenden Führungsplatten und deren Verschieben relativ zueinander auf, derart, daß jede herzustellende Bohrungsreihe mit oder ohne der hinteren Führungsplatte in jeweils einem einzigen Bohrvorgang gebohrt werden kann, wobei die zu bohrenden Führungsplatten immer dann, wenn sie vor Vornahme eines Bohrvorganges eine Relativstellung zueinander haben, die Bohren der Führungsbohrungen der betreffenden Reihe nicht in einem einzigen, zu den Führungsplatten senkrecht verlaufenden Bohrvorgang zuläßt, dann diese Führungsplatten relativ zueinander so verschoben werden, daß die Führungsbohrungen der betreffenden Führungsbohrungsreihe danach durch einen einzigen Bohrvorgang gebohrt werden können.

Die Führungsplatten können beim Bestücken mit Kontaktstiften dieselben oder ungefähr dieselben Abstände voneinander haben wie im fertigen Prüfadapter und sind auch in derselben Reihenfolge wie im fertigen Prüfadapter angeordnet. Jedoch können sie auch andere Abstände als im fertigen Prüfadapter voneinander haben, vorzugsweise etwas geringere Abstände.

Das Bohren der Führungsplatten für die einzusetzenden Kontaktstifte kann vollautomatisch erfolgen. Dabei kann man zweckmäßig so vorgehen, daß in einem Speicher die Koordinaten aller in den betreffenden Führungsplatten vorzunehmenden Bohrungen gespeichert werden und für jede Bohrungsreihe kann aus diesen Koordinaten ein Rechner die erforderliche Relativlagen der Führungsplatten zueinander berechnen, damit der jeweils vorzunehmende Bohrvorgang die Führungsbohrungen der betreffenden Bohrungsreihe durch senkrecht zu den Führungsplatten erfolgendes Bohren in diesen in einem Zuge vornehmen kann. Oder es kann vorgesehen sein, daß die für das Bohren der Führungsbohrungsreihen durch die Stellvorrichtung vorzunehmenden Verschiebungen der betreffenden Führungsplatte oder Führungsplatten in einem Speicher des Mikroprozessors gespeichert werden und vor dem Bohren der einzelnen Führungsbohrungsreihe für sie abgefragt und durch die Stellvorrichtung durchgeführt werden. Auch andere Möglichkeiten bestehen.

Entsprechend kann man beim Bestücken der Führungsplatten mit Kontaktstiften vorgehen, wobei jedoch die Führungsplatten Abstände voneinander haben, die relativ groß sind, vorzugsweise ungefähr oder genau den Abständen im fertigen Prüfadapter entsprechen oder etwas kleiner sind. Auch hier kann man die Koordinaten jeder Führungsbohrung in einem Speicher speichern und ein Rechner berechnet hieraus vor Einsetzen eines jeden Kontaktstiftes in eine Führungsbohrungsreihe die für das Einsetzen erforderliche Relativstellung der Führungsplatten zueinander und sofern erforderlich, steuert er oder eine an ihn angeschlossene Steuervorrichtung die Stellvorrichtung für die Führungsplatten in der zur Fluchtung der Führungsbohrungen der jeweiligen Führungsbohrungsreihe erforderlichen Weise an.

Für das Bohren können die zu bohrenden Führungsplatten vorzugsweise aneinander anliegen oder nur geringe Abstände voneinander haben.

Die Verschiebung der lageverstellbaren Führungsplatte oder Führungsplatten für das Bohren bzw. das Bestücken kann durch irgendeine geeignete Stellvorrichtung erfolgen. Vorzugsweise kann die Stellvorrichtung mindestens eine Kreuzschlittenanordnung aufweisen, bei der auf einem geradegeführten Schlitten ein anderer, in hierzu senkrechter Richtung geradegeführter Schlitten angeordnet ist und beide Schlitten können durch elektrische Stellmotore, vorzugsweise durch Schrittmotore, in vorzugsweise sehr kleinen Schritten verstellt werden, wobei die Stellmotore durch den Mikroprozessor angesteuert werden.

Es sei noch erwähnt, daß solche Prüfadapter zum Kontaktieren sehr unterschiedlicher Prüflinge vorgesehen sind, wobei für unterschiedliche Prüflingstypen die Führungsplatten eventuell mit Ausnahme der hinteren Führungsplatte ausgewechselt und neu mit Kontaktstiften bestückt werden müssen.

In der Zeichnung sind Ausführungsbeispiele der Erfindung dargestellt. Es zeigen:

Fig. 1 einen Schnitt durch einen Prüfadapter mit ihm zugeordneten elektrischen Kontakten zum elektrischen Anschluß seiner Kontaktstifte zur Erläuterung einer möglichen Bauart solcher Prüfadapter und des elektrischen Anschlusses,

Fig. 2 eine schematische, schaubildliche Ansicht eines Bohrautomaten zum Bohren von Führungsbohrungen in Führungsplatten für einen Prüfadapter,

Fig. 3 eine schematische, ausschnittsweise und teilweise geschnittene Vorderansicht eines Bestückungsautomaten zum Bestücken der Führungsplatten eines Prüfadapters mit Kontaktstiften,

Fig. 4 eine ausschnittweise, teilweise geschnittene Seitenansicht einer Beschickungsvorrichtung gemäß einem weiteren Ausführungsbeispiel der Erfindung.

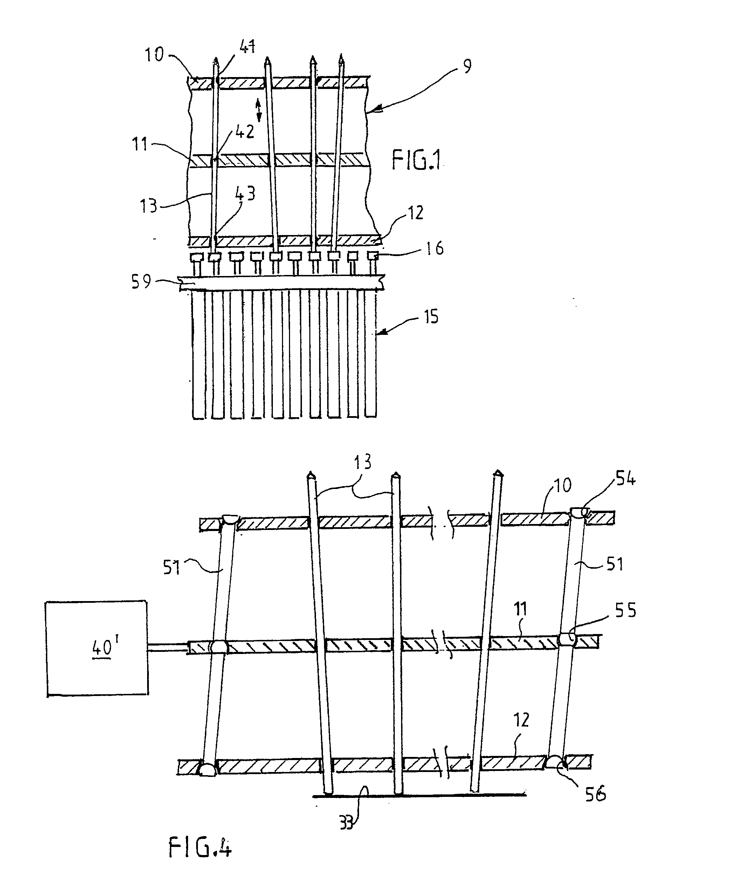

Der in Fig. 1 ausschnittsweise und geschnitten dargestellte Prüfadapter 9 weist drei in Abständen voneinander angeordnete Führungsplatten 10, 11, 12 auf, die zueinander parallel und horizontal gerichtet sind. In diesen drei Führungsplatten 10 - 12 sind Führungsbohrungen, wie 41, 42, 43 für metallische, gerade, nadelartige Kontaktstifte 13, die sogenannte Starrstifte bilden, angeordnet, die mit ihren rückwärtigen Enden auf je einem ihren elektrischen Anschluß dienenden metallischen Kontakt 16 aufsitzen. Diese Kontakte 16 sind die Köpfe von Kolbengliedern von Federkontaktstiften 15, die Hülsen aufweisen, in denen je eine das jeweilige Kolbenglied belastende Feder zur federnden Abstützung der Kontaktstifte 13 angeordnet ist. Diese Federkontaktstifte 15 sind ständig an ein nicht näher dargestelltes Prüf- oder Testgerät elektrisch angeschlossen, das in bekannter Weise selbsttätig für die jeweilige Sorte von Prüflingen programmierbar ist, so daß jeder Prüfling, der durch die betreffenden Kontaktstifte 13 des Prüfadapters 9 kontaktiert wird, auf Fehlerfreiheit getestet werden kann. Es kann auch vorgesehen sein, daß am jeweiligen Prüfling mittels des Prüf- oder Testgerätes auch Messungen vorgenommen werden, bspw. an Komponenten von bestückten Leiterplatten. Die Kontakte 16 sind an allen Gitterpunkten eines vorbestimmten Rasters angeordnet.

Drei der dargestellten Kontaktstifte 13 dienen dem Kontaktieren von außer Raster befindlichen Prüfpunkten des jeweiligen Prüflings und sind deshalb relativ zu den Ebenen der Führungsplatten 10, 11, 12 etwas schräg gerichtet, indem ihre Führungsbohrungen entsprechend etwas zueinander versetzt sind, jedoch weiterhin eine gerade Reihe bilden, so daß die Kontaktstifte in ihnen nicht gebogen werden. Die Kontaktstifte sind in den Führungsbohrungen der Führungsplatten 10, 11, 12 mit Gleitlagerspiel gelagert, so daß sie beim Kontaktieren von Prüflingen durch diese axial verschoben werden können. Einer der dargestellten Kontaktstifte ist vertikal gerichtet und und ist deshalb vertikal zu den zueinander parallelen, horizontalen, ebenen Führungsplatten 10, 11, 12 gerichtet. Die Führungsbohrungen in der hinteren (unteren) Führungsplatte 12 des Prüfadapters 9 befinden sich alle an Gitterpunkten des Rasters und fluchten so mit den ihnen nahe gegenüberliegenden Kontakten 16. Im Ausführungsbeispiel sind nur an den Stellen in der hinteren Führungsplatte 12 Führungsbohrungen, wie 43, angeordnet, wo Kontaktstifte 13 aufzunehmen sind. Diese hintere Führungsplatte 12 kann jedoch auch an allen Gitterpunkten des betreffenden Rasters Führungsbohrungen aufweisen, um sie für Prüflinge mit unterschiedlichen Prüfpunktanordnungen einsetzen zu können.

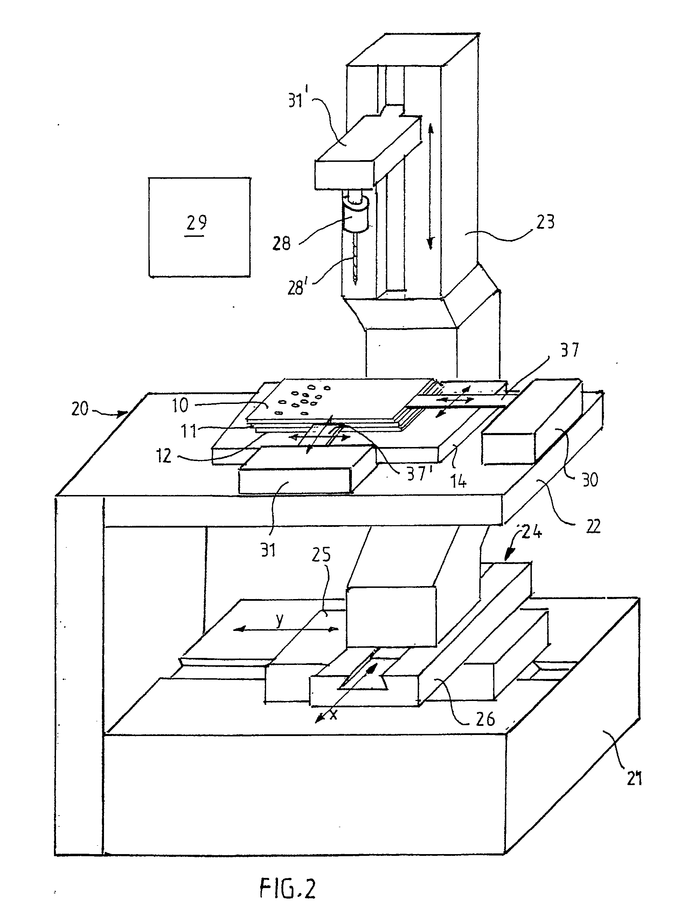

In Fig. 2 ist ein Bohrautomat zum Bohren aller für den jeweiligen Prüflingstyp jeweils benötigten Führungsplatten eines Prüfadapters oder aller Führungsplatten mit Ausnahme der hinteren Platte schaubildlich und schematisch dargestellt. Ändert sich der Prüflingstyp, dann müssen für ihn neue Führungsplatten 10, 11 oder 10, 11, 12 auf diesem Bohrautomaten gebohrt werden.

Der Bohrautomat weist ein Gestell 20 auf, das zwei an ihm fest im Abstand übereinander angeordnete Tische 21, 22 und einen aufrechten Ständer 23 aufweist.

Der Ständer 23 ist mittels einer zwei Schlitten 25 und 26 aufweisenden Kreuzschlittenanordnung 24 horizontal in zwei zueinander senkrechten Richtungen (x - und y-Richtungen) mittels nicht dargestellten Stellmotoren so verschiebbar, daß eine vom Ständer 23 getragene und an ihm vertikal auf und ab verstellbare Bohrvorrichtung 28 mit einem Bohrer 28' über jede gewünschte Stelle einer aus in diesem Ausführungsbeispiel drei aufeinanderliegenden Führungsplatten 10, 11 und 12 bestehenden Plattenanordnung bewegbar ist, um in ihnen Führungsbohrungsreihen, wie 41, 42, 43, für einzusetzende Kontaktstifte 13 (Fig. 1) in jeweils einem einzigen vertikal abwärts führenden Bohrvorgang zu bohren. In die Führungsbohrungsreihe 41, 42, 43 wurde vorangehend ein Kontaktstift 13 eingesetzt. Es ist noch eine weitere Führungsbohrungsreihe 41', 42', 43' dargestellt, in die erst nachfolgend ein Kontaktstift einzusetzen ist. Diese Führungsplatten 10 bis 12 werden von einem Support 14 getragen, der fest auf dem Tisch 22 angeordnet ist und in dem Bereich, wo der Bohrer 28' Bohrungsreihen in die Führungsplatten bohren kann, eine das Eindringen des Bohrers 28' ermöglichende Ausnehmung aufweist.

Auf diesem Support 14 ist die unterste Führungsplatte 12 fest angeordnet und auf ihr liegen die beiden anderen Führungsplatten 10, 11 auf. Jede dieser beiden Führungsplatten 10 und 11 ist mittels je eines ihr zugeordneten Stellgliedes 30, 31 horizontal in zwei zueinander senkrechten Richtungen verstellbar. Die beiden Stellglieder 30, 31 bilden zusammen eine Stellvorrichtung und weisen in je einem Gehäuse je eine nicht zu sehende Kreuzschlittenanordnung mit zwei senkrecht zueinander horizontal geradegeführten, durch je einen elektrischen Stellmotor, vorzugsweise einen Schrittmotor bewegbaren Schlitten auf. Der eine Schlitten ist auf dem anderen Schlitten angeordnet. Auch für die Schlitten 25 und 26 gilt entsprechend, daß der Schlitten 26 auf dem Schlitten 25 angeordnet ist.

Die Stellmotoren der Kreuzschlittenanordnung 24, wie auch die Stellmotoren der Schlitten der beiden Kreuzschlittenanordnungen der Stellvorrichtung 30, 31 werden von einem Mikroprozessor 29 in programmierter Weise zur Herstellung aller Führungsbohrungen in den Führungsplatten 10, 11 und 12 angesteuert.

Die Kreuzschlittenanordnung des Stellgliedes 30 dient dem Verschieben der obersten Führungsplatte 10 in x-und y-Richtungen, die horizontal und zueinander senkrecht sind. Die Kreuzschlittenanordnung des Stellgliedes 31 dient dem Verschieben der mittleren Führungsplatte 11 in horizontalen x- und y-Richtungen.

Der Schlitten 25 dient dem Verschieben des Ständers 23 in y-Richtung und der Schlitten 26 in x-Richtung.

In diesem Ausführungsbeispiel ist die unterste aufgespannte Führungsplatte 12 die Führungsplatte, deren Führungsbohrungen im Raster zu bohren sind. Die beiden anderen Führungsplatten 10, 11 müssen zum Teil mit Führungsbohrungen versehen werden, die außer Raster liegen. Die Koordinaten aller Führungsbohrungen sind im Mikroprozessor 29 gespeichert. Dieser Mikroprozessor steuert die Stellmotoren der Kreuzschlittenanordnung 24 so an, daß die Längsachse des Bohrers 28' der Bohrvorrichtung 28 nacheinander mit im Raster in der untersten Führungsplatte 12 zu bohrenden Führungsbohrungen in Fluchtung gebracht wird, wobei das Programm zweckmäßig so abläuft, daß die Verschiebewege der Bohrvorrichtung 28 möglichst kurz sind. Wenn der Bohrer 28' in eine solche, mit einer vorzunehmenden Führungsbohrung 43 in der untersten Führungsplatte 12 fluchtende Stellung gelangt ist, oder noch während der Bewegung der Bohrvorrichtung 28 in diese Stellung, werden vom Mikroprozessor 29 die vier Stellmotoren der Kreuzschlittenanordnungen der Stellglieder 30 und 31 so angesteuert, daß, falls nicht bereits die im nächsten Bohrvorgang vorzunehmenden Führungsbohrungen nicht miteinander fluchten, daß dieses miteinander Fluchten dieser Reihe von vorzunehmenden Führungsbohrungen eintritt und dann die Bohrvorrichtung 28 durch Abwärtsbewegung des sie tragenden Schlittens 31' und unter Ingangsetzung der Bohrvorrichtung 28 vertikal abwärts bewegt wird, bis die betreffende Bohrungsreihe in den Führungsplatten 10 bis 12 gebohrt ist.

Nachdem diese Bohrungsreihe gebohrt ist, fährt der Schlitten 31' wieder selbsttätig gesteuert nach oben in seine Ausgangsstellung und der Ständer 23 wird so bewegt, daß der Bohrer 28' der Bohrvorrichtung 28 mit den Längsachsen der Führungsbohrungen der nächsten herzustellenden Bohrungsreihe fluchtet, wobei danach oder schon während dem Verfahren des Ständers 23 die beiden oberen Führungsplatten 10, 11, falls erforderlich, vor dem Bohren durch die Stellvorrichtung 30, 31 angesteuert durch den Mikroprozessor 29, vorzugsweise durch eine Programmsteuervorrichtung von ihm in Stellungen verschoben werden, in denen die Längsachsen der herzustellenden Führungsbohrungen miteinander fluchten, so daß nunmehr durch Abwärtsbewegen des Schlittens 31' bei eingeschalteter Bohrvorrichtung 28 diese Führungsbohrungsreihe in einem einzigen vertikal abwärtsführenden Bohrvorgang gebohrt werden kann. Mehr oder weniger oft kommt es auch vor, daß zwischen zwei Bohrvorgängen die Führungsplatten 10 und 11 nicht verschoben werden müssen. Aber jedes Mal dann, wenn sie für einen Bohrvorgang vor dessen Beginn verschoben werden müssen, dann wird dies unter Ansteuerung durch den Mikroprozessor 29 durchgeführt.

Besonders günstig ist es, wenn, wie dargestellt, die Führungsplatten 10 bis 12 aufeinander aufliegen, da dann die Führungsplatten 11 und 12 für das Bohren eine günstige Unterstützung haben. Doch kann ggfs. auch vorgesehen sein, sie in relativ geringen Abständen vertikal übereinander anzuordnen.

Für die Relativverschiebung der Führungsplatten 10 und 11 zueinander gilt der Strahlensatz. Wenn also die Führungsplatten 10 und 11 von der Führungsplatte 12 die Abstände a und b haben und die Führungsplatte 10 durch ihr Stellglied 31 in einer bestimmten horizontalen Richtung um die Wegstrecke d verschoben wird, dann muß die Führungsplatte 11 in derselben Richtung um die Wegstrecke d x b/a (d mal b/a) verschoben werden. Man kann deshalb auch vorsehen, die den beiden Stellmotoren des Stellgliedes 30 zugeleiteten Signale, die dazu dienen, die Führungsplatte 10 um die zwecks Erhalt der Gesamtverschiebung d um die Strecken e und f zu verschieben, für die Ansteuerung der beiden Stellmotoren des Stellgliedes 31 jeweils mit b/a zu multiplizieren.

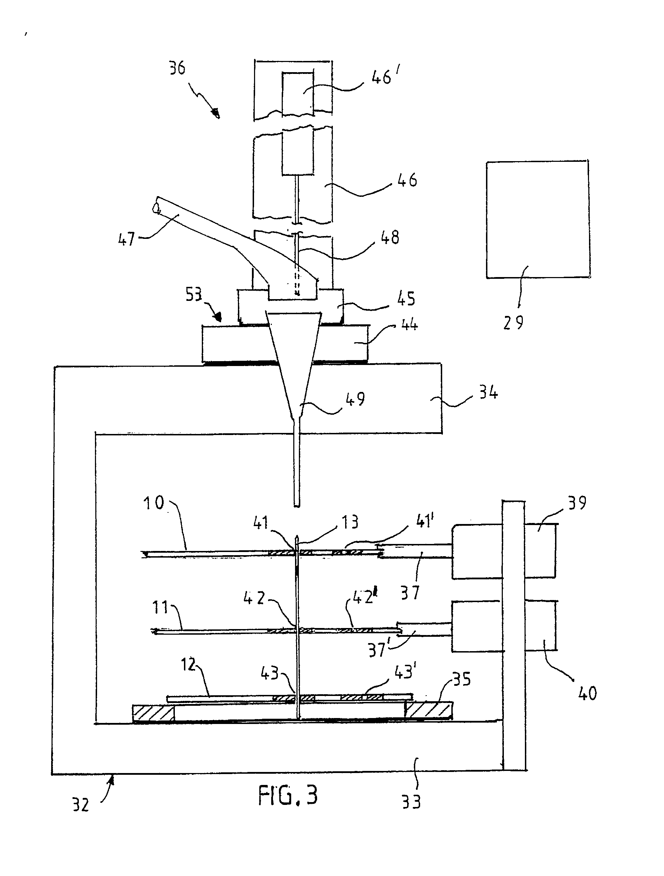

Die Bestückungsvorrichtung 36 nach Fig. 3 weist ein Gestell 32 auf, das im Abstand übereinander der zwei fest angeordnete Tische 33 und 34 aufweist.

Am unteren Tisch 33 sind drei zu bestückende Führungsplatten 10 bis 12 angeordnet. Die Führungsplatte 12 ist auf einem Support 35 befestigt, der unterhalb ihrem die Führungsbohrungen aufweisenden Feld durchbrochen ist, damit die Kontaktstifte durch die Führungsbohrungen in der unteren Führungsplatte 12 ein kurzes Stück weit hindurch dringen können.

Die Führungsplatten 10 und 11 sind an Stellgliedern 39, 40 gehalten, die ihrem horizontalen Verschieben mittels je einer in je einem Gehäuse angeordneten Kreuzschlittenanordnung mit zugeordneten Stellmotoren, die von einem Mikroprozessor 29 nach einem in ihm gespeicherten Programm ansteuerbar sind. Diese Führungsplatten 10, 11 sind an je einem sie tragenden starren Arm 37, 37' gehalten, von denen jeder an einem horizontal geradegeführten Schlitten der Stellvorrichtung 30, 31 befestigt ist. Diese beiden Schlitten sind die nicht dargestellten oberen Schlitten der Kreuzschlittenanordnungen der Stellglieder 30, 31, deren untere Schlitten horizontal und senkrecht zu den oberen Schlitten verstellbar sind. Auf diese Weise können die Führungsplatten 10 und 11 durch die beiden in den Stellgliedern 39 und 40 angeordneten Kreuzschlittenanordnungen in Verbindung mit deren zugeordneten Stellmotoren parallel und horizontal zueinander und zur Führungsplatte 12 sowohl in der zur Bildebene parallelen horizontalen x-Richtung als auch in der zur Bildebene senkrechten horizontalen y-Richtung lageverstellt werden. Die möglichen Lageverstellungen brauchen nur relativ gering zu sein. Sie dienen dazu, diejenigen Führungsbohrungen, wie 41 und 42, die vor dem jeweiligen Bohren einer Führungsbohrungsreihe nicht in Fluchtung miteinander sind, vor dem Bestücken mit einem Kontaktstift 13 in miteinander fluchtende Stellung zu bringen, so daß dann die betreffenden Führungsbohrungen 41 und 42 der Führungsplatten 10 und 11 in Fluchtung mit der zugeordneten Führungsbohrung 43 in der Führungsplatte 12 sind.

Auf dem oberen Tisch 34 ist eine Kreuzschlittenanordnung 53 angeordnet, deren unterer Schlitten 44 auf dem Tisch 34 geradegeführt ist in zur Bildebene paralleler horizontaler Richtung und durch einen nicht dargestellten Stellmotor verschiebbar ist. Der obere Schlitten 45 ist auf dem unteren Schlitten 44 in horizontaler, senkrecht zur Bildebene verlaufender gerader Richtung mittels eines ebenfalls nicht dargestellten Stellmotors hin und her beweglich und trägt einen starren Ständer 46, der an ihm fest angeordnet ist, an dem ein Hub- oder Arbeitszylinder 46' in vertikaler Stellung eine vertikale Stoßstange oder Stempel 48 trägt.

An dem Ständer 46 ist ferner ein Rohr 47 gehalten, das dem aufeinanderfolgenden Zuführen von Kontaktstiften 13 zu einem im oberen Bereich trichterförmig erweiterten Führungsrohr 49 dient, dessen an den Trichter anschließender kreiszylindrischer Führungskanal einen lichten Durchmesser hat, der geringfügig größer als der Durchmesser der Kontaktstifte 13 ist.

Das Führungsrohr 49 ist wie das Rohr 47 mit dem Ständer 46 unbeweglich verbunden.

Zum Bestücken der Führungsplatten 10 bis 12 mit Kontaktstiften 13 werden die Stellmotoren der Schlitten 44, 45 der Kreuzschlittenanordnung 53 von einem Mikroprozessor so programmgesteuert betätigt, welche Stellmotoren ebenfalls vorzugsweise elektrische Schrittmotoren sein können, daß das Führungsrohr 49 aufeinanderfolgend jeweils in Fluchtung mit je einer in der Führungsplatte 12 vorhandenen Führungsbohrung kommt, in die ein Kontaktstift 13 einzusetzen ist. Der Mikroprozessor 29 steuert gleichzeitig oder danach oder vorher die Stellmotoren der in den Stellgliedern 39, 40 befindlichen Kreuzschlittenanordnungen programmgesteuert so an, daß die der betreffenden Führungsbohrung, bspw. der Führungsbohrung 43, der Führungsplatte 12 zugeordneten Führungsbohrungen, bspw. die Führungsbohrungen 41, 42, in den Führungsplatten 10, 11 in Fluchtung mit der betreffenden Führungsbohrung in der Führungsplatte 12 kommen, falls dies nicht bereits schon vorher der Fall war. Dann wird durch das Rohr 47 ein Kontaktstift 13 dem auf diese Führungsbohrungsreihe, bspw. der Führungsbohrungsreihe 41, 42, 43 zielenden Führungsrohr 49 zugeleitet und fällt so unter vertikaler Ausrichtung und Fluchtung mit dieser Führungsbohrungsreihe zu ihr und gelangt zumindest in die oberste Führungsbohrung und ggfs. gleich auch durch die beiden anderen Führungsbohrungen dieser Führungsbohrungsreihe hindurch in seine endgültige, in Fig. 3 an einem Beispiel dargestellte Stellung. Ist letzteres nicht der Fall, dann wird dieses völlige Einsetzen des Kontaktstiftes 13 in die Führungsbohrungsreihe durch den Stempel 48 bewirkt, da dieser nach jedesmaligem Zuleiten eines Kontaktstiftes 13 in das Führungsrohr 49 durch den Arbeitszylinder 46' so weit nach unten bewegt wird, daß der Kontaktstift 13 in alle drei zugeordneten Führungsbohrungen bis praktisch zum Aufsitzen auf dem Tisch 33 eingeschoben wird. Danach wird der Stempel 48 durch den Arbeitszylinder 46' wieder nach oben in seine Ausgangsstellung bewegt und der Ständer 46 so weiter bewegt, daß das Führungsrohr 49 mit der nächsten programmierten zu bestückenden Führungsbohrung 43 fluchtet. In diesem Ausführungsbeispiel ist dabei dargestellt, daß bei Fluchtung der Führungsbohrungen 41 bis 43 die benachbarte Führungsbohrung 43' nicht mit den ihr zugeordneten Führungsbohrungen 41' und 42' in den Führungsplatten 10 und 11 fluchtet, so daß vor dem Einsetzen eines Kontaktstiftes in sie zunächst die Stellmotoren der Stellglieder 39, 40 deren Kreuzschlittenanordnungen unter programmierter Steuerung ihrer Stellmotoren durch den Mikroprozessor 29 die Führungsplatten 10 und 11 so verschieben müssen, daß ihre Führungsbohrungen 41', 42' und 43' miteinander fluchten und dann wird der Vorgang des Einsetzen eines Kontaktstiftes 13 in diese vorangehend in Fluchtung mit dem Führungsrohr 49 verschobene Führungsbohrungsreihe wie beschrieben wiederholt. Dies erfolgt solange, bis alle zu bestückenden Führungsbohrungen mit Kontaktstiften bestückt sind.

Dieser Bestückungsvorgang kann vollautomatisch gesteuert durch den Mikroprozessor 29 ablaufen und benötigt pro Kontaktstift 13 nur sehr wenig Zeit.

Die Kontaktstifte 13 sind nadelartig und haben außer ihren dem Kontaktieren von Prüflingen dienenden Spitzen kreiszylindrische Gestalt. Es können jedoch auch Kontaktstifte vorgesehen sein, an deren rückwärtigen oder vorderen Enden verbreiterte Köpfe vorgesehen sind. In einem solchen Fall sind die Führungsplatten 10 bis 12 so anzuordnen, daß die verbreiterten Enden der Kontaktstifte an den bei ihrem Einsetzen rückwärtigen Enden vorhanden sind.

Sobald die Bestückung der Führungsplatten 10 bis 12 mit Kontaktstiften 13 beendet ist, können diese mit Kontaktstiften bestückten Führungsplatten von der dargestellten Bestückungsvorrichtung abgenommen und in den Prüfadapter eingebaut werden, wobei lediglich darauf zu achten ist, daß die Kontaktstifte nicht aus den Führungsbohrungen herausfallen können. Wenn die Kontaktstifte keine verbreiterten Enden haben, kann man zum Verhindern des Herausfallens der Kontaktstifte beim Überführen und beim Einbau der bestückten Führungsplatten 10 bis 12 in den Prüfadapter vorsehen, daß die Kontaktstifte mit ihren unteren Enden auf einer beim Bestücken auf dem Tisch 33 aufgelegten Platte aufsitzen, die zusammen mit den Führungsplatten zum Prüfadapter gebracht wird und dort erst entfernt wird, wenn diese Führungsplatten 10 bis 12 in den vorgesehenen Stellungen über den Federkontaktstiften 15 (Fig. 1) angeordnet sind. Man zieht dann lediglich die Platte seitlich heraus.

Anstatt die parallel zu sich selbst lageverstellbaren Führungsplatten - in Fig. 3 sind dies die Führungsplatten 10 und 11, jedoch können es auch noch mehr Führungsplatten sein - durch je ein gesondertes Stellglied 39, 40 parallel zu sich selbst in der x-und y-Richtung lagezuverstellen, kann unter baulicher Vereinfachung und auch der Programmierung vorgesehen sein, wie an einem Ausführungsbeispiel in Fig. 4 dargestellt, die Führungsplatten 10, 11, 12, gleichgültig ob es drei oder noch mehr Führungsplatten sind, durch Gelenkstangen 51 in Art einer räumlichen Parallelogrammführung bewegungszukoppeln, wobei diese Bewegungskopplung in den Ebenen der Führungsplatten sowohl in x-Richtung als auch in y-Richtung wirkt, also diese Führungsplatten beliebig parallel zu sich selbst durch das dann nur noch benötigte einzige Stellglied 40' jeweils so zu verschieben, daß vor Durchführung eines Bestückungsvorganges einer Führungsbohrungsreihe deren Führungsbohrungen miteinander fluchten. Um die Bewegungskopplung in x- und y-Richtung zu bewirken, sind die Gelenkstangen mittels Kugelgelenken 54, 55 und 56 mit den Führungsplatten 10, 11 und 12 praktisch spielfrei gelenkig verbunden.

Zu diesem Zweck durchdringen die Gelenkstangen 51 Durchbrüche der beiden äußeren Führungsplatten 10 und 12 und in diese Bohrungen sind von außen her Kugelpfannen eingesetzt, in denen kugelflächenförmige Endabschnitte der Gelenkstangen in der Art von Kugelgelenken gelagert sind. In Höhe der Führungsplatte 11 weisen die Gelenkstangen 51 je eine Kugelzone auf, die in je einem kugelzonenförmigen Abschnitt der Führungsplatte 11 gleitbar gelagert sind. Um die Gelenkstangen 51 in die Führungsplatten 10 bis 12 einsetzen zu können, können sie bspw. 2-teilig ausgebildet sein. Infolge dieser Gelenkstangen 51 ergibt sich stets von selbst, daß die Bohrungen jeder Führungsbohrungsreihe in Fluchtung miteinander sind, wenn die Führungsbohrung der durch die Stellvorrichtung 40' lageverstellbaren Führungsplatte 11 in Fluchtung mit der zugeordneten Führungsbohrung in der unteren Führungsplatte 12 gelangt ist.

Diese Gelenkstangen 51 bewirken, wie man ohne weiteres erkennt, daß stets die Führungsbohrungen jeder zu bohrenden Führungsbohrungsreihe nach dem Strahlensatz ständig in gerader Reihe angeordnet sind, so daß, wenn nur die Führungsbohrung in der mittleren Führungsplatte 11 in Fluchtung mit der zugeordneten Führungsbohrung in der unteren Führungsplatte 12 gebracht wird, dann auch die zugeordnete Führungsbohrungen in der oberen Führungsplatte 10 mit diesen beiden Führungsbohrungen fluchtet.

**Patentansprüche**

1. Verfahren zum Bohren und/oder Bestücken der auswechselbaren Führungsplatten eines Prüfadapters, welcher dem Kontaktieren von Prüfpunkten von Prüflingen, insbesondere von Leiterplatten, zu deren Prüfung dient, welcher Prüfadapter n zueinander parallele, in Abständen voneinander angeordnete Führungsplatten aufweist, wo n mindestens drei ist, in welchen Führungsplatten zueinander parallele Führungsbohrungen zur Aufnahme von geraden, elektrisch leitenden nadelartigen Kontaktstiften angeordnet sind, wobei die Führungsbohrungen für die Kontaktstifte in der hinteren Führungsplatte an Gitterpunkten eines vorbestimmten Rasters angeordnet sind und die Führungsbohrungen für die Kontaktstifte in den anderen Führungsplatten zumindest teilweise außer diesem Raster sind, wobei jeder Kontaktstift in einer Reihe von Führungsbohrungen in gerader Gestalt und mit geringem Gleitlagerspiel angeordnet ist, und zumindest einige solche Führungsbohrungsreihen so angeordnet sind, daß die in sie eingesteckten Kontaktstifte dem Kontaktieren von Prüfpunkten von außer Raster liegenden Prüflingen dienen, dadurch gekennzeichnet, daß zum Bohren der Führungsbohrungen (41 - 43) alle Führungsplatten (10 - 12) oder n-1 Führungsplatten (10, 11) aufeinander gelegt oder in geringen Abständen voneinander angeordnet werden und in diesen Führungsplatten die Reihen von Führungsbohrungen nacheinander in pro Reihe jeweils einem einzigen Bohrvorgang gebohrt werden, wobei diejenigen Reihen von Führungsbohrungen, deren Längsachsen vor dem Bohren nicht miteinander fluchten, vor der Vornahme des jeweiligen Bohrvorganges in Fluchtung ihrer Führungsbohrungen durch Verschieben mindestens einer der Führungsplatten gebracht werden, und/oder daß die Kontaktstifte (13) in die Führungsbohrungen (41, 42, 43) aller Führungsplatten (10, 11, 12) nacheinander eingesetzt werden, wobei die Führungsbohrungen jeder Führungsbohrungsreihe vor Einsetzen des betreffenden Kontaktstiftes, falls sie außer Fluchtung sind, durch Verschieben von vorzugsweise n - 1 Führungsplatten (10, 11) parallel zu sich selbst in Fluchtung gebracht werden.

2. Verfahren nach Anspruch 1, dadurch gekennzeichnet, daß die Führungsplatten beim Bestücken mit Kontaktstiften Abstände voneinander haben, die ungefähr den Abständen im fertiggestellten Prüfadapter entsprechen.

3. Verfahren nach Anspruch 1 oder 2, dadurch gekennzeichnet, daß für den Prüfadapter insgesamt drei Führungsplatten mit Führungsbohrungen für die Kontaktstifte verwendet werden.

4. Verfahren nach einem der vorhergehenden Ansprüche, dadurch gekennzeichnet, daß die Kontaktstifte (13) in vertikalen Stellungen und Richtungen in die ebenfalls vertikal angeordneten Reihen von Führungsbohrungen (41, 42, 43) eingesteckt werden.

5. Vorrichtung zur Durchführung des Verfahrens nach Anspruch 1 oder 3, dadurch gekennzeichnet, daß sie eine Bohrvorrichtung (28), vorzugsweise einen Bohrautomaten, aufweist, die dem aufeinanderfolgenden Bohren der Führungsbohrungsreihen von n oder n - 1 Führungsplatten dient, welche Führungsplatten dabei aufeinanderliegend oder in geringen Abständen voneinander angeordnet sind, daß eine Stellvorrichtung (39, 40, 40') vorgesehen ist, mittels der vor dem Bohren einer Führungsbohrungsreihe, falls die Längsachsen der zu bohrenden Führungsbohrungen nicht miteinander fluchten, mindestens eine der Führungsplatten (10, 11) so parallel zu sich selbst verschoben wird, daß die Längsachsen der zu bohrenden Führungsbohrungen dieser Führungsbohrungsreihe miteinander fluchten, so daß dann durch den Bohrer (28') der Bohrvorrichtung (28) die Führungsbohrungen dieser Führungsbohrungsreihe in einem einzigen Bohrvorgang bohrbar sind.

6. Vorrichtung zur Durchführung des Verfahrens nach einem der Ansprüche 1 bis 4, dadurch gekennzeichnet, daß sie eine Bestückungsvorrichtung (36), vorzugsweise einen Bestückungsautomaten, zum Bestücken aller Führungsplatten (10, 11, 12) mit Kontaktstiften (13) aufweist, welche dem aufeinanderfolgenden Einsetzen der Kontaktstifte in die jeweils zugeordneten Führungsbohrungsreihen der Führungsplatten dient, und daß Haltemittel für die Führungsplatten zu deren zueinander parallelem Halten in Abständen, vorzugsweise in den nach Einbau in den Prüfadapter vorliegenden Abständen voneinander vorgesehen ist, wobei eine Stellvorrichtung (39, 40; 40') zum Verstellen von n-1 dieser Führungsplatten (10, 11) parallel zu sich selbst und ein Mikroprozessor (29) vorgesehen sind, der dem Ansteuern der Stellvorrichtung in der Weise dient, daß die n-1 dieser Führungsplatten, falls die Führungsbohrungen (41, 42, 43) der Führungsbohrungsreihe, in die jeweils ein Kontaktstift (13) einzusetzen ist, außer Fluchtung miteinander sind, vor Einsetzen des jeweiligen Kontaktstiftes so verschoben werden, daß alle Führungsbohrungen (41, 42, 43) der betreffenden Führungsbohrungsreihe miteinander fluchten, vorzugsweise vertikal miteinander fluchten.

7. Vorrichtung nach Anspruch 6, dadurch gekennzeichnet, daß die zu bestückenden Führungsplatten (10, 11, 12) durch starre Gelenkstangen (51) so miteinander bewegungsgekoppelt sind, daß lediglich durch Verschieben einer einzigen Führungsplatte (11) durch die Stellvorrichtung (40') außer Fluchtung befindliche Führungsbohrungen jeder beliebigen mit einem Kontaktstift (13) zu bestückenden Führungsbohrungsreihe in Fluchtung miteinander überführbar sind.

8. Vorrichtung nach Anspruch 7, dadurch gekennzeichnet, daß die Gelenkstangen (51) an den Führungsplatten (10, 11, 12) in Art von Kugelgelenken gelagert sind.

9. Vorrichtung nach einem der Ansprüche 6 - 9, dadurch gekennzeichnet, daß eine Kontaktstift-Führungsvorrichtung (49) vorgesehen ist, die dem zielendem Zuführen der Kontaktstifte zu den Führungsbohrungsreihen dient, welche vorzugsweise ein lageverstellbares Führungsrohr aufweist.

FIG.1

FIG.4

FIG.2

FIG.3